# EUROPÄISCHE PATENTANMELDUNG

(11) **EP 3 056 952 A1**
(43) Veröffentlichungstag der Anmeldung: **17.08.2016**
(21) Anmeldenummer: 15000432.3
(22) Anmeldetag: 12.02.2015
(51) Int. Cl.: G05B 17/02, G05B 19/418, G06F 17/50

(54) **Entwerfen einer Maschine mittels Entscheidungspfad**

(71) Anmelder: Siemens Aktiengesellschaft, 80333 München (DE)
(72) Erfinder: LAHR, Torsten, 90408 Nürnberg (DE)

(57) **Zusammenfassung**

Maschinen sollen im Nachhinein leichter geändert oder umgerüstet werden können. Dazu wird ein Verfahren und eine Vorrichtung zum Entwerfen einer Maschine durch vorgeben einer ersten Anforderung (A1) an die zu entwerfende Maschine und Auswählen eines ersten Merkmals der Maschine, das die erste Anforderung (A1) erfüllt, durch eine erste Entscheidung (e12) vorgeschlagen. Es erfolgt ein automatisches Aufzeichnen der ersten Anforderung (A1) und der ersten Entscheidung (e12) in einem Entscheidungspfad. Daraufhin wird ein zweites Merkmal der Maschine ausgewählt, das mit der ersten Entscheidung (e12) kompatibel ist, indem eine zweite Entscheidung (e22) getroffen wird. Auch hier erfolgt ein automatisches Aufzeichnen der zweiten Entscheidung (e22) in dem Entscheidungspfad mit Bezug auf die erste Entscheidung (e12).

## Beschreibung

Die vorliegende Erfindung betrifft ein Verfahren zum Entwerfen einer Maschine durch Vorgeben einer Anforderung an die zu entwerfende Maschine und Auswählen eines Merkmals der Maschine, das die Anforderung erfüllt, durch eine Entscheidung. Darüber hinaus betrifft die vorliegende Erfindung eine entsprechende Vorrichtung zum Entwerfen einer Maschine. Ferner bezieht sich die vorliegende Erfindung auch auf ein Verfahren zum Herstellen einer Maschine mit einem derartigen Maschinenentwurf.

Kürzere Produktionslebenszyklen und individuellere Produkte verlangen bei produzierenden Unternehmen eine schnellstmögliche Anpassung ihres Produktionsprozesses hinsichtlich einer optimierten Prozesskette. Durch neue Produktionsverfahren und integrierte Prozesse wird ein erhebliches Optimierungspotenzial freigesetzt. Dies führt zu einem steigenden Bedarf an kundenindividuellen Maschinen. Folge davon ist wiederum, dass eine entsprechende Sondermaschinenentwicklung höchst effizient gestaltet werden muss. Im Wesentlichen können zwei Kategorien von Ansätzen zur schnelleren Maschinenentwicklung identifiziert werden. Die erste versucht, Maschinen strikt zu modularisieren, wodurch die Modulentwicklung von der Auftragsabwicklung getrennt wird. Die zweite Kategorie fokussiert auf die Beschleunigung des Entwicklungsprozesses. Darauf geht die vorliegende Erfindung näher ein. Darüber hinaus kann das erfindungsgemäße Verfahren auch die Auftragsabwicklung (konkrete Ausprägung) einer modularen Maschine unterstützen.

Die Planung einer Maschine basiert auf einer gegebenen Anforderungslage. Basierend auf dieser Anforderungslange werden im Maschinenentwurf und im Detailengineering Entscheidungen getroffen, die Limitierungen für die Maschine ergeben. So werden beispielsweise Entscheidungen bezüglich der Festlegung der maximalen Größe des Rohteils, bezüglich der Festlegung auf bestimmte Wirkprinzipien oder bezüglich einer Auswahl von Hardware und Software getroffen. Diese Entscheidungen stehen alle in einem weiteren oder engeren Bezug zueinander. Die Reihe von Entscheidungen wird unter Einbezug verschiedener Hilfsmittel (z. B. morphologischer Kasten, Entscheidungstabellen, Produktkonfiguratoren) getroffen. Ein "Entscheidungspfad" entsteht hin zur konkreten Maschine. Die getroffenen Entscheidungen werden, wenn sie indirekt oder direkt dokumentiert werden, häufig losgelöst in Projekten oder Dokumenten in verschiedenen Systemen (Word, CAD, etc.) festgehalten.

Ändert sich nun die Anforderungslage an die Maschine, so ist eine Entscheidung zu treffen, ob eine neue Maschine oder eine Erweiterung/Umrüstung der Maschine am kostengünstigsten ist. Um dies zu tun, muss abgeschätzt werden, welche Aufwendungen für eine Umrüstung notwendig sind. Dieser Verlauf ist ebenso in den meisten Entwicklungsprozessen für Produkte, Maschinen oder Produktionsanlagen zu finden. Bezogen auf die Maschine kann dieses Szenario sowohl beim Maschinenbetreiber (Nachrüsten) als auch beim Maschinenbauer (Innovation) eintreten.

Heute werden, wie oben angedeutet wurde, zur Bewertung der Aufwände für eine Erweiterung/Umrüstung der Maschine die getroffenen Entscheidungen aus der Engineering-Dokumentation oder aus der Maschine selbst nachvollzogen. Die Entscheidungen unterliegen keiner Ordnung. Zusammenhänge bzw. Abhängigkeiten von Entscheidungen müssen oftmals mühsam wieder erarbeitet werden. Geänderte Anforderungen bedingen die Rücknahme bestimmter getroffener Entscheidungen und das Ermitteln bzw. Festlegen der geänderten Entscheidung anhand von technischen Regeln. Ist beispielsweise eine größere Masse zu transportieren, so ändert sich die Lastkurve einer Achse. Ein neuer Motor muss ermittelt werden. Dieser neue Motor bedingt einen anderen Antrieb.

Der Einsatzbereich der vorliegenden Erfindung ist sehr weitreichend. Grundsätzlich lässt sich damit beinahe jede Maschine herstellen. Besonders vorteilhaft ist natürlich die Herstellung von Sondermaschinen mit geringer Stückzahl. Bei diesen Maschinen ist der Aufwand gegenüber den übrigen Herstellungskosten verhältnismäßig hoch. Ein typisches Beispiel einer solchen Sondermaschine wäre eine Firmwarelademaschine, von denen weltweit nur sehr wenige hergestellt werden. Eine weitere Möglichkeit für den Einsatz der vorliegenden Erfindung wäre bei der Herstellung von Maschinen denkbar, die zur Schleifwalzenproduktion dienen. Es können aber auch Großmaschinen und Anlagen von der Erfindung profitieren, wie etwa Reifenproduktionsmaschinen, Gepäckförderanlagen und dergleichen. Darüber hinaus können auch beispielsweise spezielle Roboter oder Werkzeugmaschinen mit dem erfindungsgemäßen Verfahren entworfen und hergestellt werden.

Die Aufgabe der vorliegenden Erfindung besteht darin, eine Vorrichtung und ein Verfahren anzugeben, die das Entwerfen einer Maschine im Hinblick auf spätere Änderungen erleichtern.

Erfindungsgemäß wird diese Aufgabe gelöst durch ein Verfahren zum Entwerfen einer Maschine durch
- Vorgeben einer ersten Anforderung an die zu entwerfende Maschine,
- Auswählen eines ersten Merkmals der Maschine, das die erste Anforderung erfüllt, durch eine erste Entscheidung,
- automatisches Aufzeichnen der ersten Anforderung und der ersten Entscheidung in einem Entscheidungspfad,
- Auswählen eines zweiten Merkmals der Maschine, das mit der ersten Entscheidung kompatibel ist, durch eine zweite Entscheidung und
- automatisches Aufzeichnen der zweiten Entscheidung in dem Entscheidungspfad mit Bezug auf die erste Entscheidung.

Darüber hinaus wird erfindungsgemäß bereitgestellt eine Vorrichtung zum Entwerfen einer Maschine mit
- einer Auswahleinrichtung zum Auswählen eines ersten Merkmals der Maschine, das eine vorgegebene erste Anforderung erfüllt, durch eine erste Entscheidung,
   und
- einer Speichereinrichtung zum automatischen Aufzeichnen der ersten Anforderung und der ersten Entscheidung in einem Entscheidungspfad, wobei
- die Auswahleinrichtung ausgelegt ist zum Auswählen eines zweiten Merkmals der Maschine, das mit der ersten Entscheidung kompatibel ist, durch eine zweite Entscheidung und
- die Speichereinrichtung ausgelegt ist zum automatischen Aufzeichnen der zweiten Entscheidung in dem Entscheidungspfad mit Bezug auf die erste Entscheidung.

Der Begriff Maschine wird hier sehr breit verstanden. Wie bereits erwähnt kann darunter jede Art von Maschinen, aber auch beispielsweise Roboter, Produktionsanlagen, Bearbeitungsanlagen und dergleichen fallen. Ein typisches Beispiel für eine Maschine wäre insbesondere eine Werkzeugmaschine.

In vorteilhafter Weise geht man zunächst von der üblichen Vorgabe einer Anforderung an die Maschine aus, und es wird ein entsprechendes erstes Merkmal der Maschine durch eine Entscheidung ausgewählt, wobei dieses Merkmal so ausgebildet ist, dass die Maschine die Anforderung erfüllt. Nun wird in vorteilhafter Weise die erste Anforderung und die erste Entscheidung gegebenenfalls mit einer ersten Auswirkung, die die erste Entscheidung mit sich bringt, in einem Entscheidungspfad automatisch aufgezeichnet bzw. abgespeichert. Damit ist die Entscheidung auch später ohne Weiteres nachvollziehbar. Entlang des Entscheidungspfads wird nun ein zweites Merkmal der Maschine, das mit der ersten Entscheidung (d.h. auch deren Auswirkung) kompatibel ist, ausgewählt, indem eine zweite Entscheidung getroffen wird. Die erste Entscheidung hat damit unmittelbaren Einfluss auf die zweite Entscheidung. Auch diese zweite Entscheidung wird nun in dem Entscheidungspfad automatisch aufgezeichnet. Damit ist also auch im Nachhinein rekonstruierbar, wie es zu der zweiten Entscheidung in dem Entscheidungspfad gekommen ist.

Die oben angesprochenen Merkmale der Maschine können jeweils eine Größe eines Bauteils, ein Wirkprinzip des Bauteils, eine Hardwarekomponente oder eine Softwarekomponente betreffen. Für all diese Komponenten stehen in der Regel mehrere Varianten zur Verfügung, die für die Maschine jeweils passend ausgesucht werden müssen.

Gegebenenfalls wird bei dem Auswählen des zweiten Merkmals eine Kompatibilität mit einer zweiten Anforderung überprüft wird, und bei dem automatischen Aufzeichnen der zweiten Entscheidung ein Bezug zu der zweiten Anforderung in dem Entscheidungspfad aufgezeichnet. Nach diesem Prinzip können auch weitere Entscheidungen und Anforderungen in den Entscheidungspfad aufgenommen werden, wobei nicht zu jeder Entscheidung eine neue Anforderung hinzukommen muss. Es kann sich auch eine Anforderung auf mehrere Entscheidungen auswirken. Dies bedeutet, dass die erste Anforderung identisch mit der zweiten Anforderung sein kann.

Unter Umständen wird nun die erste Anforderung in eine alternative erste Anforderung geändert. Beispielsweise ist eine höhere Masse zu transportieren oder es muss von einer 12 V-Spannungsversorgung auf eine 230 V-Spannungsversorgung umgestellt werden. In diesem Fall wird vorzugsweise entsprechend dem Entscheidungspfad automatisch angegeben, welche Entscheidung oder Entscheidungen von der ersten Anforderung abhängen. Durch diese Angabe kann sofort erkannt werden, welche Konsequenzen diese Änderung der Anforderung für die Maschine hat. Insbesondere ist dadurch leicht zu erkennen, ob eventuell nur eine Komponente oder wenige Komponenten der Maschine ausgetauscht werden müssen, oder ob die gesamte Maschine neu zu konstruieren ist.

Bei einer solchen Änderung der Anforderung ist es vorteilhaft, wenn aufgrund der alternativen ersten Anforderung automatisch anstelle der ersten Entscheidung eine alternative erste Entscheidung vorgeschlagen wird. Stehen nämlich komplizierte Alternativen oder eine Vielzahl von Alternativen zur Verfügung, so ist ein automatischer Vorschlag für den Bediener in jedem Fall von Vorteil.

Wiederum kann die alternative erste Entscheidung zusammen mit einer alternativen ersten Auswirkung automatisch in einem alternativen Entscheidungspfad aufgezeichnet werden, wenn die vorgeschlagene alternative erste Entscheidung angenommen wird. Damit wird automatisch wieder ein kompletter Entscheidungspfad mit Entscheidungen und gegebenenfalls Auswirkungen systematisch ermittelt und aufgezeichnet.

Jede der Anforderungen kann eine Geometrie, ein Gewicht oder eine elektrische Größe eines Bauteils oder einer Baugruppe der zu entwerfenden Maschine betreffen. Die Anforderungen sind jedoch nicht auf die genannten Beispiele beschränkt. Von der Logik her sind Anforderungen und Auswirkungen von Entscheidungen gleichzusetzen. Anforderungen stellen die ursprünglichen Bedingungen für nachfolgende Entscheidungen dar. Auswirkungen hingegen ergeben sich aus Entscheidungen und stellen wiederum Bedingungen für nachfolgende Entscheidungen dar.

In dem alternativen Entscheidungspfad kann auch eine alternative zweite Entscheidung mit Bezug auf die erste alternative Entscheidung aufgezeichnet werden, wenn aufgrund der ersten alternativen Entscheidung die zweite alternative Entscheidung getroffen wird. Eine solche alternative zweite Entscheidung kann also notwendig sein, wenn anstelle der ersten Entscheidung eine alternative erste Entscheidung getroffen wird. Der Bezug besteht im einfachsten Fall darin, dass die Entscheidungen als Paar oder Sequenz aufgezeichnet werden. Auch die alternative zweite Entscheidung kann eine alternative zweite Auswirkung oder mehrere Auswirkungen besitzen, welche sich wiederum auf nachfolgende Entscheidungen oder auf eine Gesamtbeurteilung auswirken.

Vorzugsweise wird durch die vorliegende Erfindung auch ein Verfahren zum Herstellen einer Maschine durch Entwerfen der Maschine entsprechend den oben beschriebenen Verfahrensschritten und Fertigen der Maschine entsprechend dem resultierenden Entwurf bereitgestellt. Der Entwurf mit dem jeweils aktuellen aufgezeichneten Entscheidungspfad ist also Grundlage für einen anschließenden Fertigungsprozess. Bei diesem Fertigungsprozess spiegelt sich jede der getroffenen Entscheidungen dadurch wieder, dass die einzelnen Maschinenkomponenten entsprechend dem Entscheidungspfad gewählt bzw. konfiguriert werden.

Die oben im Zusammenhang mit dem erfindungsgemäßen Verfahren geschilderten Merkmale können jeweils auch als Funktion für die Auswahleinrichtung bzw. die Speichereinrichtung der erfindungsgemäßen Vorrichtung verstanden werden.

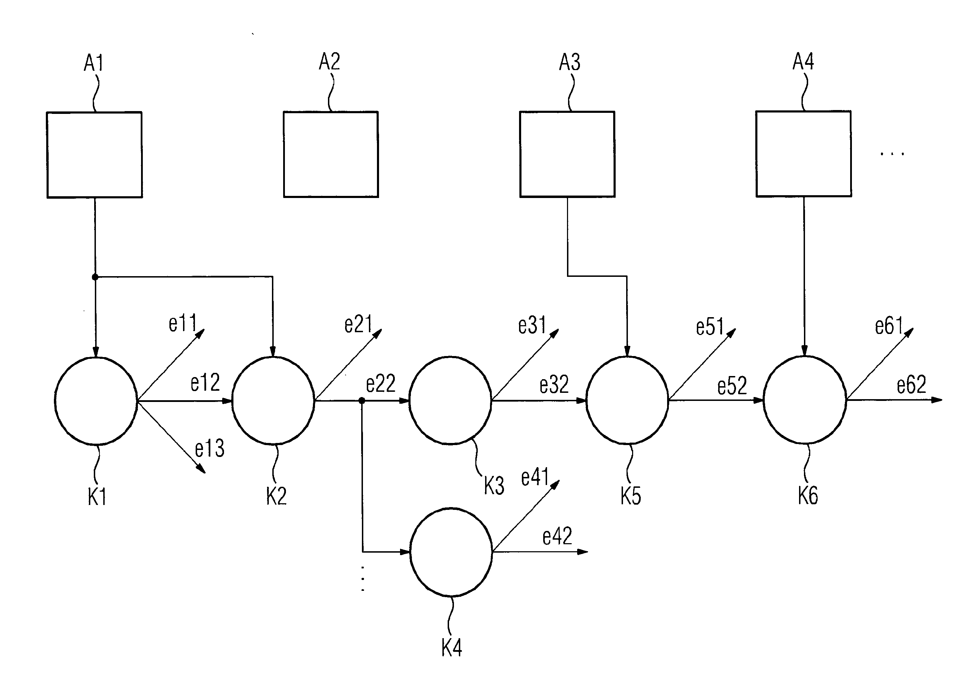

Die vorliegende Erfindung wird nun anhand der beigefügten Zeichnung näher erläutert, die schematisch das Entstehen eines Entscheidungspfads wiedergibt.

Die nachfolgend näher geschilderten Ausführungsbeispiele stellen bevorzugte Ausführungsformen der vorliegenden Erfindung dar. Dabei ist zu beachten, dass die einzelnen Merkmale des jeweiligen Verfahrens bzw. der jeweiligen Vorrichtung nicht nur in der geschilderten Kombination, sondern auch in Alleinstellung oder in einer anderen technisch sinnvollen Kombination realisiert werden können.

Bei der Entwicklung von elektrischen Maschinen, insbesondere Werkzeugmaschinen, Fertigungsanlagen oder Robotern, unterscheidet man die Disziplinen Mechanik, Elektrik und Automatisierung, die meist ineinandergreifend auf den Entwicklungsprozess Einfluss nehmen. In jeder dieser Disziplinen wird jeweils ein Modell entwickelt, wobei in der Regel mehrere interdisziplinäre Iterationen notwendig sind. Für jedes Modell müssen im Laufe des Entwicklungsprozesses ausgehend von einer Reihe von Anforderungen üblicherweise zahlreiche Entscheidungen getroffen werden. Beispielsweise muss entschieden werden, wie viele Achsen die Maschine haben soll. Außerdem muss entschieden werden, welcher Antrieb für die jeweilige Achse gewählt werden soll. All diese Entscheidungen wirken sich nicht nur auf die Mechanik der Maschine, sondern auch auf die Elektrik und auf die Automatisierung dieser Maschine aus. Es gibt aber auch Anforderungen oder Entscheidungen, die sich im Wesentlichen nur auf eine Disziplin oder ein Modell auswirken, z. B. die Entscheidung, welcher Frequenzumrichter verwendet werden soll. Andere Anforderungen bzw. Entscheidungen wiederum beziehen sich eher auf die Mechanik bzw. das mechanische Modell, wie z. B. die Anforderung, dass eine bestimmte Schräge oder eine Tasche gefertigt werden soll.

Betrachtet man nun ein einzelnes Modell oder alle Modelle zusammen, so ergibt sich jeweils im Laufe des Entwicklungsprozesses ein Entscheidungsverlauf. Ausgehend von einer oder mehreren Anforderungen werden nämlich sukzessive Entscheidungen getroffen, bis sämtliche Komponenten der Maschinen feststehen und der Entwurf bzw. das Modell vollständig entwickelt ist. Es wird nun angestrebt, dass der Entscheidungsverlauf bzw. der Entscheidungspfad, der im Laufe des Entwicklungsprozesses entsteht, auch später nachvollziehbar ist, um gegebenenfalls Änderungen an der Maschine zielgerichtet vornehmen zu können.

Es werden daher alle beim Entwurf und der Planung der Maschine getroffenen Entscheidungen in geordneter bzw. systematischer Form in dem Entscheidungsverlauf bzw. Entscheidungspfad verknüpft mit den der jeweiligen Entscheidung zugrundeliegenden Anforderungen und/oder den vorausgehenden Entscheidungen bzw. deren Auswirkungen. Entsprechende spezifische Ausprägungen werden z. B. in disziplinspezifischen Autorensystemen (z. B. MCAD-System oder ECAD-System) in einer umfassenden Datenhaltung dokumentiert. So wird beispielsweise in einem ECAD-System der Entscheidungsverlauf Motor-Steuerung-Stromlauf mit den entsprechenden Entscheidungen dokumentiert, und in einem MCAD-System der Entscheidungsverlauf MotorGehäuse-Aufhängung.

In der beigefügten Figur ist die Entscheidungsfindung, die in einen entsprechenden Entscheidungspfad mündet, für ein konkretes Beispiel dargestellt. So liegen beispielsweise vier Anforderungen A1 bis A4 vor. Die erste Anforderung A1 kann sich auf das Abnahmeteil beziehen, das die zu entwerfende Maschine produzieren soll. Beispielsweise soll das Abnahmeteil eine spezielle Geometrie wie etwa eine Tasche oder eine Schräge aufweisen. Die zweite Anforderung A2 kann die Abmaße eines Rohteils betreffen. Danach richtet sich beispielsweise der Abstand, den ein Werkzeug von einem Werkzeughalter mindestens haben muss. Die weitere Anforderung A3 betrifft beispielsweise das Gewicht des zu fertigenden Teils. Dies wirkt sich beispielsweise auf die Antriebe aus, die das Teil bewegen müssen. Darüber hinaus kann sich die vierte Anforderung A4 beispielsweise auf das elektrische Netz beziehen. So kann beispielsweise vorgegeben sein, dass zur Stromversorgung ein Drehstromnetz mit einer Spannung von 400 V und einer Frequenz von 50 Hz dient. Es können natürlich auch weitere Anforderungen, andere Anforderungen oder weniger Anforderungen gegeben sein.

Jede dieser Anforderungen A1 bis A4 kann sich nun auf die im Entwicklungsprozess zu treffenden Entscheidungen auswirken. Gegebenenfalls sind die zu treffenden Entscheidungen zumindest teilweise entsprechend einer vorgegebenen Priorität hintereinander zu treffen. So sind grundlegende Entscheidungen eher am Anfang und Detailfragen eher am Ende des Entscheidungsverlaufs zu klären. Im vorliegenden Beispiel betrifft eine erste Entscheidung die Frage, welches Maschinenkonzept zu verwenden ist. Diese Frage wird in der Figur mit dem Knoten K1 symbolisiert. Sie kann beispielsweise im vorliegenden Fall mit den drei Entscheidungen e11, e12 und e13 beantwortet werden. Wird wie hier die Entscheidung e12 getroffen, so hat diese Entscheidung Auswirkung auf die weiteren Entscheidungen. Wird hingegen die Entscheidung e11 oder e13 getroffen, so hat die jeweilige Entscheidung entweder keine Auswirkung auf die folgenden Entscheidungen oder sie hat jeweils Auswirkung auf andere Entscheidungen, die im vorliegenden Beispiel nicht näher dargestellt sind. Im vorliegenden Beispiel wird also gemäß Entscheidung e12 ein bestimmtes Maschinenkonzept gewählt.

Die getroffene Entscheidung e12 bzw. das gewählte Maschinenkonzept wirken sich nun auf die nächste Frage "Wie viele Achsen?", die durch Knoten K2 symbolisiert ist, aus. Auf diese Frage der Anzahl der Achsen wirkt sich aber auch die erste Anforderung A1 aus, die die Art des Abnahmeteils (z. B. dessen Geometrie) vorgibt. Es ist also im Knoten K2 eine Entscheidung zu treffen, die mit der ersten Entscheidung e12 und im vorliegenden Beispiel auch mit der Anforderung A1 kompatibel ist. Im vorliegenden Beispiel stehen in dem Knoten K2 die Entscheidungen e21 und e22 zur Verfügung. Beispielsweise steht die Entscheidung e21 dafür, dass drei Achsen in der Maschine zur Verfügung gestellt werden müssen und die Entscheidung e22 dafür, dass vier Achsen zur Verfügung gestellt werden müssen. Beispielsweise wird nun die Entscheidung e22 für die vier Achsen getroffen.

Um später den Entscheidungsverlauf nachvollziehen zu können, wird automatisch die Anforderung A1 zusammen mit der Entscheidung e12 und der Entscheidung e22 aufgezeichnet. Da die Entscheidung e22 getroffen bzw. aufgezeichnet wurde und diese Entscheidung mit der vorhergehenden Entscheidung e12 kompatibel sein muss, ist mit der Aufzeichnung der beiden Entscheidungen e22 und e12 implizit auch die Auswirkung der Entscheidung e12 festgehalten. Wäre nämlich die Entscheidung e11 gefallen, so würde nicht der Knoten K2 erreicht werden und es müsste nicht die Frage nach der Anzahl der Achsen entschieden werden. Jedenfalls könnte dann nicht die Entscheidung e22 folgen. Die Entscheidungsfolge e12-e22 gibt also zwangsläufig wieder, welche Knoten auf dem Entscheidungspfad liegen, nämlich hier K1 und K2. Die Reihenfolge der Entscheidungen gibt dann deren Bezug bzw. deren Auswirkung in der Aufzeichnung wieder. Der Entscheidungspfad ist also gerichtet. Die Entscheidung e22 ist nach der Entscheidung e12 zu treffen. Es wirkt sich also die Entscheidung e12 auf die Entscheidung e22 aus, aber nicht umgekehrt.

Die Entscheidung e22 muss hier auch die Anforderung A1 berücksichtigen. Daher wird hier zu der Entscheidung e22 auch die Anforderung A1, also deren Bezug dazu, aufgezeichnet. Eine Anforderung, die für die zweite Entscheidung e22 zu berücksichtigen ist, kann also gleich der Anforderung sein, die bei der ersten Entscheidung e12 zu berücksichtigen ist. Die Anforderungen, die für die jeweiligen Entscheidungen zu berücksichtigen sind, können jedoch auch unterschiedlich sein. Darüber hinaus kann auch eine Anforderung, z. B. A2, an den Entwurf gestellt sein, die sich nicht auf die Entscheidungen auswirkt oder zumindest nicht auf die Entscheidungen in dem Modell einer Disziplin.

Die Entscheidung e22, wonach vier Achsen zur Verfügung gestellt werden sollen, wirkt sich nun auf mehrere Knoten K3, K4 und gegebenenfalls weitere Knoten aus. Im Knoten K3 soll nämlich die Frage "Welches Wirkprinzip für Achse 1?" geklärt werden. Dort steht die Entscheidung e31 für eine lineare Achse und die Entscheidung e32 für eine Kugelrollspindel zur Verfügung. Ähnliches kann für den Knoten K4 gelten, in dem die Frage "Welches Wirkprinzip für Achse 2?" zu klären ist. Zusätzliche Anforderungen wirken sich hier nicht auf die Fragen bzw. Entscheidungen e31, e32, e41, e42 aus.

Der Entscheidungsverlauf wird der Einfachheit halber nur entlang der Entscheidung e32 weiterverfolgt. Diese Entscheidung e32 wirkt sich im Knoten K5 beispielsweise auf die Frage "Welcher Motor?" aus. Auf diese Frage bzw. Entscheidung wirkt sich beispielhaft auch die Anforderung A3 aus, gemäß der das Gewicht des von der Maschine zu fertigenden Teils spezifiziert wird. Je nachdem wird ein stärkerer oder schwächerer Motor eingesetzt. Im vorliegenden Beispiel wird demgemäß die Entscheidung e52 getroffen.

Die Entscheidung e52 wirkt sich nun in dem Knoten K6 auf die Frage "Welcher Frequenzumrichter?" aus. Zusätzlich wirkt sich auf diese Frage die Anforderung A4 aus, die beispielsweise das elektrische Netz spezifiziert. Es wird daraufhin die Entscheidung e61 und e62 getroffen, welche beide mit der Entscheidung e52 kompatibel sind. Nicht kompatibel wären diese Entscheidungen e61 und e62 beispielsweise mit der vorhergehenden Entscheidungsmöglichkeit e51.

Der Entscheidungsverlauf kann auf diese Weise fortgebildet werden. Insbesondere gilt dies auch für die Verzweigung nach dem Knoten K4. Selbstverständlich sind die hier getroffenen Entscheidungen sowie deren Auswirkungen und die Auswirkungen der Anforderungen hier rein beispielhaft zu sehen.

Aufgezeichnet bzw. abgespeichert wird hier der Entscheidungspfad e12-e22-e32-e52 gegebenenfalls mit weiteren Entscheidungen e61 oder e62 und e41 oder e42. Die Reihenfolge gibt deren Bezug wieder. Es können aber auch spezielle Links oder andere Bezugsindikatoren mit aufgezeichnet werden. Daneben werden A1 bis A4 etc. aufgezeichnet, jeweils mit Bezug auf die entsprechenden Entscheidungen, auf die sie sich auswirken.

Das automatische Aufzeichnen kann mit Vollendung des Entscheidungspfads erfolgen. Alternativ kann auch nach jeder einzelnen Entscheidung eine entsprechende automatische Aufzeichnung erfolgen.

Sobald der Entscheidungspfad komplett ist, steht ein fertiges Modell zur Verfügung. Dieses fertige Modell ist entweder disziplinübergreifend oder kann mit anderen Modellen zu einem Gesamtmodell zusammengefügt werden. In jedem Fall entsteht dadurch ein disziplinübergreifender Entwurf der herzustellenden Maschine. Die Herstellung erfolgt dann entsprechend dem Entwurf.

Bei Änderung der Anforderungslage können nun systemgestützt (automatisch) die Stellen im Entscheidungspfad identifiziert werden, die abgeändert werden müssen. Mit Einbezug von technischen Regelwerken (z. B. in Produktkonfiguratoren wie SIZER) entscheidet (empfiehlt) das System den alternativen Entscheidungspfad. Der Anwender muss gegebenenfalls nur noch bestätigen. Ändert sich beispielsweise gemäß Anforderung A3 das Gewicht des zu fertigenden Teils, so ist die Frage "Welcher Motor?" neu zu überdenken. Ein entsprechend geeigneter Motor kann aufgrund der Anforderung automatisch vorgeschlagen werden. Eine diesbezügliche zielgerichtete Änderung kann aber nur deswegen unternommen werden, weil der gesamte Entscheidungspfad einschließlich der Anforderungen mit deren Bezügen aufgezeichnet wurde. Wäre diese Aufzeichnung nicht erfolgt, so könnte nicht sofort beurteilt werden, ob sich die geänderte Anforderung nicht auch auf andere Entscheidungen bzw. Fragen wie beispielsweise das Maschinenkonzept auswirkt. Gleichzeitig kann aus dem aufgezeichneten Entscheidungspfad auch sofort erkannt werden, dass sich die Anforderung A3 nicht nur auf die im Knoten K5 zutreffende Entscheidung auswirkt, sondern auch auf die damit kompatiblen nachfolgenden Entscheidungen, wie im vorliegenden Beispiel die Entscheidungen e61 und e62.

Durch den aufgezeichneten Entscheidungspfad einschließlich der Anforderungen lässt sich also rasch beurteilen, ob eine geänderte Anforderungslage eine Änderung der Maschine erlaubt, oder ob die Maschine besser komplett neu aufgebaut wird.

In vorteilhafter Weise erfolgt also erfindungsgemäß in einer bevorzugten Ausgestaltung ein geordnetes Festhalten der während der Maschinenplanung festgehaltenen Entscheidungen mit Verknüpfungen der zugrundeliegenden Anforderungen und dadurch bedingten Auswirkungen sowie den Beziehungen der Entscheidungen untereinander in einem Entscheidungspfad. Dies ermöglicht die Rücknahme von Entscheidungen durch geänderte Anforderungen. Darüber hinaus ergibt sich dadurch vorzugsweise eine umfassende Datenhaltung aller in der Planung anfallenden Daten in einem moderierten IT-System als Basis für die Aufzeichnung des Entscheidungspfads. Außerdem kann ein nahtloser Einbezug von technischen Regelwerken in das IT-System zur Datenhaltung gewährleistet werden. Dies ermöglicht das Ermitteln eines alternativen Pfads der jeweiligen Entscheidung.

## Patentansprüche

**1.** Verfahren zum Entwerfen einer Maschine durch
- Vorgeben einer ersten Anforderung (A1) an die zu entwerfende Maschine,
- Auswählen eines ersten Merkmals der Maschine, das die erste Anforderung (A1) erfüllt, durch eine erste Entscheidung (e12),
**gekennzeichnet durch**
- automatisches Aufzeichnen der ersten Anforderung (A1) und der ersten Entscheidung (e12) in einem Entscheidungspfad,
- Auswählen eines zweiten Merkmals der Maschine, das mit der ersten Entscheidung (e12) kompatibel ist, **durch** eine zweite Entscheidung (e22) und
- automatisches Aufzeichnen der zweiten Entscheidung (e22) in dem Entscheidungspfad mit Bezug auf die erste Entscheidung (e12).

**2.** Verfahren nach Anspruch 1, wobei jedes der Merkmale eine Größe eines Bauteils, ein Wirkungsprinzip des Bauteils, eine Hardware-Komponente oder eine Software-Komponente betrifft.

**3.** Verfahren nach Anspruch 1 oder 2, wobei bei dem Auswählen des zweiten Merkmals eine Kompatibilität mit einer zweiten Anforderung überprüft wird, und bei dem automatischen Aufzeichnen der zweiten Entscheidung (e22) ein Bezug zu der zweiten Anforderung in dem Entscheidungspfad aufgezeichnet wird.

**4.** Verfahren nach einem der vorhergehenden Ansprüche, wobei die erste Anforderung (A1) in eine alternative erste Anforderung geändert wird und entsprechend dem Entscheidungspfad automatisch angegeben wird, welche der Entscheidungen einen Bezug zu der ersten Anforderung (A1) hat/haben.

**5.** Verfahren nach Anspruch 4, wobei auf Grund der alternativen ersten Anforderung automatisch anstelle der ersten Entscheidung (e12) eine alternative erste Entscheidung vorgeschlagen wird.

**6.** Verfahren nach Anspruch 5, wobei die alternative erste Entscheidung automatisch in einem alternativen Entscheidungspfad aufgezeichnet wird, wenn die vorgeschlagene alternative erste Entscheidung angenommen wird.

**7.** Verfahren nach einem der vorhergehenden Ansprüche, wobei jede Anforderung eine Geometrie, ein Gewicht oder eine elektrische Größe eines Bauteils oder einer Baugruppe der zu entwerfenden Maschine betrifft.

**8.** Verfahren nach Anspruch 6 oder 7, wobei in dem alternativen Entscheidungspfad eine alternative zweite Entscheidung mit Bezug auf die alternative erste Entscheidung aufgezeichnet wird, wenn auf Grund der alternativen ersten Entscheidung die alternative zweite Entscheidung getroffen wird.

**9.** Verfahren nach Anspruch 8, wobei in dem alternativen Entscheidungspfad die alternative zweite Entscheidung auch mit Bezug auf die zweite Anforderung oder eine alternative zweite Anforderung aufgezeichnet wird, wenn bei der alternativen zweiten Entscheidung die Kompatibilität der zweiten Anforderung oder der alternativen zweiten Anforderung berücksichtigt wird.

**9.** Verfahren zum Herstellen einer Maschine durch Entwerfen der Maschine gemäß einem der vorhergehenden Ansprüche und Fertigen der Maschine entsprechend dem resultierenden Entwurf.

**10.** Vorrichtung zum Entwerfen einer Maschine mit
- einer Auswahleinrichtung zum Auswählen eines ersten Merkmals der Maschine, das eine vorgegebene erste Anforderung (A1) erfüllt, durch eine erste Entscheidung (e12),
**gekennzeichnet durch**
- eine Speichereinrichtung zum automatischen Aufzeichnen der ersten Anforderung (A1) und der ersten Entscheidung (e12) in einem Entscheidungspfad, wobei
- die Auswahleinrichtung ausgelegt ist zum Auswählen eines zweiten Merkmals der Maschine, das mit der ersten Entscheidung (e12) kompatibel ist, **durch** eine zweite Entscheidung (e22) und
- die Speichereinrichtung ausgelegt ist zum automatischen Aufzeichnen der zweiten Entscheidung (e22) in dem Entscheidungspfad mit Bezug auf die erste Entscheidung (e12).
